# EUROPÄISCHE PATENTSCHRIFT

(11) **EP 4 455 514 B1**
(45) Veröffentlichungstag und Bekanntmachung des Hinweises auf die Patenterteilung: **12.11.2025**
(21) Anmeldenummer: 24170628.2
(22) Anmeldetag: 16.04.2024
(51) Int. Cl.: F16H 57/04

(54) **ANTRIEBSSTRANG**
DRIVE TRAIN
GROUPE MOTOPROPULSEUR

(30) Priorität: 26.04.2023 DE 102023203886
(43) Veröffentlichungstag der Anmeldung: 30.10.2024
(73) Patentinhaber: VOLKSWAGEN AG, 38440 Wolfsburg (DE)
(72) Erfinder: Nennstiel, Lukas, 34117 Kassel (DE); Schröder, Thomas, 12307 Berlin (DE); Müller, Frank, 38165 Essenrode (DE); Warnecke, Raimar, 38179 Groß Schwülper (DE)

(56) Entgegenhaltungen:
- US-A1- 2022 205 529
- US-A1- 2023 120 835
- US-B2- 11 608 883

## Beschreibung

Die Erfindung betrifft einen Antriebsstrang mit den Merkmalen des Oberbegriffes des Patentanspruches 1.

Im Stand der Technik sind Antriebsstränge für E-Fahrzeuge mit einem Getriebe, mit einer Leistungselektronik und mit einem Gehäuse bekannt. Mittels der Leistungselektronik ist die einer E-Maschine des E-Fahrzeugs zuführbare oder aus einer solchen E-Maschine abführbare Energie umwandelbar, z.B. um eine Kopplung der E-Maschine mit einer Batterie zu ermöglichen.

Aus der WO 2020/207537 A1 ist ein solcher Antriebsstrang bekannt, in dessen Gehäuse horizontal nebeneinander liegend, ein Leistungselektronikraum, ein Getrieberaum und ein E-Maschinenraum ausgebildet sind. Das Getriebe und/oder zumindest zwei Zahnräder zur Ausbildung von zumindest einer Getriebestufe des Getriebes ist bzw. sind in dem Getrieberaum und die Leistungselektronik ist in dem Leistungselektronikraum angeordnet. Der Getrieberaum und der Leistungselektronikraum sind mit Hilfe einer Trennwand voneinander getrennt. An einer Außenseite des Gehäuses im Bereich des Leistungselektronikraums ist ein Wärmetauscher teilweise mit einem Gehäusedeckel für den Leistungselektronikraum ausgebildet. Ein Ölkreislauf des Getriebes mit einer Ölpumpe und ein Kühlkreislauf der E-Maschine mit einer Kühlmittelpumpe sind an jeweils eine Seite dieses Wärmtauschers angeschlossen. Mittels des Wärmtauschers ist eine Wärmeübertragung zwischen einem in dem Ölkreislauf zirkulierendem Getriebeöl und einem in dem Kühlkreislauf zirkulierendem Kühlfluid ermöglicht.

Eine derartiges Wärmemanagement des Getriebeöls ist konstruktiv und steuerungstechnisch aufwendig umzusetzen. Es sind dabei zumindest die zwei genannten Pumpen vorzusehen und deren Steuerung und/oder Regelung durchzuführen. Weiterhin sind die strömungstechnischen Verbindungen zwischen diesen Pumpen und dem Wärmtauscher mit entsprechend hohem Aufwand zu erstellen. Zusätzlich ist zum Betrieb der beiden Pumpen Energie bereitzustellen, was sich negativ auf einen Wirkungsgrad des Antriebsstranges auswirkt.

Aus der EP 2 161 479 A1 ist ein Getriebe bekannt, in dessen Gehäuse Kühlkanäle vorgesehen sind. Diese Kühlkanäle sind mit den Kühlkanälen einer Brennkraftmaschine verbunden. Mittels in den Kühlkanal hineinragender Rippen ist eine mäanderförmige Strömung von dem Kühlfluid durch den Kühlkanal ermöglicht.

Die Kühlung des im Getriebe vorhandenen Getriebeöls ist hier aber noch nicht optimal ausgeführt. Insbesondere ist der Anteil des Getriebeöls welcher, und die Zeit in welcher das Getriebeöl angrenzend zu den Kühlkanälen vorhanden ist, nur schwer kontrollierbar, so dass die Temperaturänderung des Getriebeöls nicht genau bekannt bzw. vorbestimmbar ist. Somit ist die Steuerung- und/oder Regelung des Getriebes, insbesondere dessen Kühlung erschwert bzw. problematisch.

Die DE 10 2018 220 496 A1 schließlich zeigt einen weiteren Antriebsstrang mit einer E-Maschine, mit einem Getriebe, mit einer Leistungselektronik und mit einem gemeinsamen Gehäuse. Die Leistungselektronik ist an der Oberseite des gemeinsamen Gehäuses angeordnet. In dem Getriebe ist ein Ölsumpf ausgebildet, in welchem sich im Betrieb Getriebeöl sammelt. Das Getriebeöl ist aus dem Ölsumpf mit einer Ölpumpe den zu kühlenden und/oder zu schmierenden Bauteilen der E-Maschine und/oder des Getriebes zuführbar. Angrenzend zum Ölsumpf sind Kühlkanäle in dem Gehäuse ausgebildet. Das Gehäuse weist Rippen auf, welche im Ölsumpf mit Kontakt zum Getriebeöl angeordnet sind, um mittels der Rippen den Wärmeübergang von in den Kühlkanälen vorhandenem Kühlfluid an das Getriebeöl zu verbessern.

Im Ölsumpf bewegt sich das Getriebeöl aber im Wesentlichen nicht oder nur sehr wenig, wodurch der Wärmeübergang an das Getriebeöl verringert ist, da dieser Wärmeübergang an das Getriebeöl im Wesentlichen lediglich durch Wärmeleitung mit einer entsprechend niedrigen Wärmeübergangskoeffizienten erfolgt.

So ist aus der US 2023/0120835 A1 ein Antriebsstrang bekannt, der ein Getriebe und eine Leistungselektronik aufweist. Hierbei ist ein Getrieberaum und ein Leistungselektronikraum in einem Gehäuse ausgebildet, wobei der Getrieberaum und der Leistungselektronikraum mit Hilfe einer Trennwand voneinander getrennt sind. Weiterhin wird das im Ölsumpf vorhandene Getriebeöl durch mindestens ein Zahnrad empor geschleudert und ist einem Auffangbehälter zuführbar.

Es sind weiterhin Getriebe mit einem Auffangbehälter bekannt, in deren Betrieb mit Hilfe zumindest eines der Zahnräder des Getriebes, das im Ölsumpf vorhandene Getriebeöl emporschleuderbar und somit dem Auffangbehälter zuführbar ist. Aus dem Auffangbehälter ist das Getriebeöl dann den zu kühlenden und/oder zu schmierenden Bauteilen der E-Maschine und/oder des Getriebes zuführbar.

Der Erfindung liegt nun die Aufgabe zugrunde, den Antriebsstrang nun derart auszugestalten und / oder weiterzubilden, dass die im Vorhinein genannten Probleme vermieden, zumindest aber reduziert sind, insbesondere wobei dann das Getriebeöl einfacher und effektiver kühlbar ist.

Diese der Erfindung zugrunde liegende Aufgabe wird nun zunächst durch einen Antriebsstrang mit den Merkmalen des Patentanspruches 1 gelöst.

Ein Aspekt liegt zunächst im Wesentlichen darin, dass die Trennwand mindestens einen Kühlkanal aufweist, wobei der Auffangbehälter zumindest teilweise beabstandet zur Trennwand angeordnet ist, wobei ein Getriebeöl-Kühlbereich zwischen dem Auffangbehälter und der Trennwand ausgebildet ist, wobei der Auffangbehälter einen Überlauf aufweist, wobei das Getriebeöl über den Überlauf dem Getriebeöl-Kühlbereich zuführbar, mit Hilfe der Schwerkraft durch den Getriebeöl-Kühlbereich hindurch führbar, und dabei mit Hilfe des im Kühlkanal vorhandenen Kühlfluides abkühlbar ist.

Auf diese Weise ist keine Ölpumpe notwendig, um das Getriebeöl selbst abzukühlen und auch nicht um mittels des Getriebeöls die Bauteile des Getriebes zu kühlen und/oder zu schmieren. Somit ist das Kühlen des Getriebeöls selbst und das Kühlen und/oder Schmieren der Bauteile des Getriebes besonders einfach und mit geringem vorrichtungstechnischen sowie auch steuerungs- und/oder regelungstechnischem Aufwand durchführbar. Es wird dabei vorteilhafterweise auch zu einem nennenswerten Anteil die Schwerkraft zur Förderung des Getriebeöls genutzt, so dass insgesamt beim Betrieb des Antriebsstranges Energie einsparbar ist. Bei der Kühlung des Getriebeöls ist ein konvektiver Wärmeübergang zwischen der Trennwand und dem Getriebeöl mit entsprechend hohem Wärmeübergangskoeffizienten realisiert.

In einer bevorzugten Ausführungsform des Antriebsstranges weist der Auffangbehälter an der der Trennwand zugewandten Seite zumindest eine Behälter-Rippe auf. Mittels dieser Behälter-Rippe ist der Wärmübergang zwischen dem Getriebeöl und dem Kühlfluid im Getriebeöl-Kühlbereich verbesserbar, da das Getriebeöl mittels der Behälter-Rippe der Trennwand zuleitbar ist.

In einer weiteren, besonders bevorzugten Ausführungsform des Antriebsstranges weist die Trennwand an der dem Auffangbehälter zugewandten Seite zumindest eine Trennwand-Rippe auf. Auch mittels der Trennwand-Rippe ist der Wärmübergang zwischen dem Getriebeöl und dem Kühlfluid im Getriebeöl-Kühlbereich verbesserbar, da das Getriebeöl insbesondere mittels der Trennwand-Rippe umwälzbar ist, so dass dann bei der Durchströmung des Getriebeöl-Kühlbereiches durch das Getriebeöl immer wieder andere "noch Warme" Bereiche des Getriebeöls mit der Trennwand in Kontakt kommen, um dort abgekühlt zu werden, um dann wieder, weitere "wärmere" Bereiche des Getriebeöls zur Trennwand zu leiten. Somit ist dann der konvektive Wärmeübergang zwischen der Trennwand und dem Getriebeöl verbessert und der zugehörige Wärmeübergangskoeffizient erhöht. Weiterhin ist mittels der Trennwand-Rippe die Fläche für den Wärmeübergang zwischen der Trennwand und dem Getriebeöl vergrößert und somit der Wärmeübergang hier weiter verbessert.

Bevorzugterweise weist der Auffangbehälter zumindest zwei Behälter-Rippen und die Trennwand zumindest zwei Trennwand-Rippen auf. Die Behälter-Rippen und die Trennwand-Rippen sind wechselsinnig angeordnet, so dass mit Hilfe der Behälter-Rippen und der Trennwand-Rippen mäanderförmige Strömungskanäle des Getriebeöl-Kühlbereiches ausgebildet sind. Auf diese Weise sind die oben genannten Effekte der Zuführung des Getriebeöls zur Trennwand hin und die der Umwälzung des Getriebeöls besonders gut kombiniert, und insbesondere einfach kontrollierbar bzw. während einer Auslegung des Getriebeöl-Kühlbereiches vorbestimmbar. Durch die wechselsinnig angeordneten Behälter-Rippen und Trennwand-Rippen, insbesondere die mäanderförmigen Strömungskanäle, ist der Strömungsweg des Getriebeöls durch den Getriebeöl-Kühlbereich vorteilhafterweise verlängert.

Gemäß einer vorteilhaften Ausführungsform des Antriebsstranges sind die Behälter-Rippen und die Trennwand-Rippen im Wesentlichen waagerecht ausgerichtet. Mittels der Behälter-Rippen ist somit das Getriebeöl besonders gut mit Hilfe der Schwerkraft der Trennwand zuleitbar. Das Getriebeöl strömt z.B. aus dem Überlauf senkrecht nach unten, trifft dann auf die Behälter-Rippe und wird mittels der Behälter-Rippe aufgrund der im Wesentlichen waagerechten Anordnung um im Wesentlichen 90° umgelenkt, so dass ein Großteil des Getriebeöls anschließend in Richtung der Trennwand strömt. Mittels der im Wesentlichen waagerecht ausgerichteten Trennwand-Rippen ist die Umwälzung des Getriebeöls weiter verbessert, insbesondere in Kombination mit den Wesentlichen waagerecht ausgerichteten Behälter-Rippen. Mit im Wesentlichen waagerecht ist in diesem Zusammenhang gemeint, dass auch eine leichte Schrägstellung der Behälter-Rippen und der Trennwand-Rippen von vorzugsweise bis zu 5° bis 10° Grad denkbar ist, solange eben sichergestellt ist, dass der Großteil des Getriebeöls mittels der Behälter-Rippen in Richtung der Trennwand umgelenkt wird und dass eine ausreichend große Umwälzung des Getriebeöls erreicht wird. Wenn der Antriebsstrang selbst in einem Fahrzeug eingebaut ist, könnte ein solches Fahrzeug auch schräg ausgerichtet sein, z.B. beim Herauf- oder Herunterfahren einer Steigung. Die waagerechte Ausrichtung der Behälter-Rippen und der Trennwand-Rippen ist dann insbesondere bei einer waagerechten Ausrichtung des Fahrzeuges erreicht.

Weiter bevorzugt sind die Behälter-Rippen und die Trennwand-Rippen unterhalb des Überlaufes, unterhalb einer Überlaufkante des Überlaufes, angeordnet und/oder ausgebildet. Das Getriebeöl strömt dann im Betrieb des Antriebsstranges aus dem Auffangbehälter den Behälter-Rippen und den Trennwand-Rippen zu. Da das Getriebeöl im Wesentlichen aufgrund der Schwerkraft durch den Getriebeöl-Kühlbereich strömt, wären oberhalb des Überlaufes angeordnete Behälter-Rippen und/oder Trennwand-Rippen wenig zielführend im Sinne der Kühlung des Getriebeöls, da das Getriebeöl die Trennwand im Betrieb des Antriebsstranges im Wesentlichen unterhalb des Überlaufes kontaktiert.

Das Getriebeöl ist gemäß einer bevorzugten Ausführungsform des Antriebsstranges aus dem Getriebeöl-Kühlbereich, mit Hilfe der Schwerkraft, dem Ölsumpf zuführbar. So ist ein Getriebeölkreislauf vervollständigt. Das Getriebeöl wird dann im Betrieb des Antriebsstranges aus dem Ölsumpf emporgeschleudert, mittels des Auffangbehälters aufgefangen, aus welchem es durch den Überlauf in den Getriebeöl-Kühlbereich einströmt, um von dort nach dessen Durchströmung wieder in den Ölsumpf zurückzuströmen.

Bevorzugterweise liegt die Leistungselektronik zumindest teilweise, unter Ausbildung einer wärmeleitenden Verbindung, an der Trennwand an. Somit ist die Leistungselektronik besonders gut mit Hilfe des in dem Kühlkanal vorhandenen Kühlfluides abkühlbar.

Die Leistungselektronik ist vorteilhafterweise zumindest teilweise angrenzend zum Kühlkanal, insbesondere zumindest teilweise auf gleicher Höhe wie der Kühlkanal, in dem Leistungselektronikraum angeordnet. Der Überlauf ist zumindest teilweise angrenzend bzw. gegenüberliegend zum Kühlkanal, insbesondere zumindest teilweise auf gleicher Höhe wie der Kühlkanal, in dem Getrieberaum angeordnet, so dass das Getriebeöl über den Überlauf einem angrenzend zum Kühlkanal ausgebildeten Teilbereich des Getriebeöl-Kühlbereiches unmittelbar zuführbar ist.

Durch die Anordnung der Leistungselektronik zumindest teilweise angrenzend zum Kühlkanal, insbesondere zumindest teilweise auf gleicher Höhe des Kühlkanals, ist die Wärmeübertragung zwischen dem in dem Kühlkanal vorhandenen Kühlfluid und der Leistungselektronik weiter verbessert, eben durch eine Minimierung des zwischen dem Kühlfluid und der Leistungselektronik angeordneten Materials, insbesondere der Trennwand. Anders ausgedrückt sind auf diese Weise besonders hohe Wärmeübergangskoeffizienten zwischen dem Kühlfluid und der Leistungselektronik erreichbar.

Durch die Anordnung des Überlaufs zumindest teilweise angrenzend bzw. gegenüberliegend zum Kühlkanal, insbesondere zumindest teilweise auf gleicher Höhe wie der Kühlkanal, ist auch der Wärmeübertragung zwischen dem in dem Kühlkanal vorhandenen Kühlfluid und dem Getriebeöl weiter verbessert. Das dann beim Erreichen des Getriebeöl-Kühlbereiches noch besonders warme Getriebeöl kommt dann direkt mit dem aufgrund der hier angrenzenden Kühlkanäle besonderes kalten Bereich der Trennwand in Kontakt. Der sich dann ausbildende hohe Temperaturgradient zwischen dem Getriebeöl und der Trennwand führt eben auch zu dem besonders hohen Wärmeübergang.

In einer weiteren Ausführungsform des Antriebsstranges weist die Trennwand mehrere, gerade verlaufende Kühlkanäle auf, wobei die Kühlkanäle mit Hilfe jeweils einer in das Gehäuse eingebrachten Bohrung ausgebildet sind. Dabei weisen die Kühlkanäle einen bestimmten Winkel zu den Behälter-Rippen und den Trennwand-Rippen auf.

Derartige Kühlkanäle sind besonders einfach und kostengünstig herstellbar. Durch die Ausbildung des Winkels sind die Kühlkanäle trotz der einfachen Ausbildung der Kühlkanäle in einem großen Bereich der Trennwand angrenzend des Getriebeöl-Kühlbereiches ausbildbar, insbesondere zumindest teilweise angrenzend bzw. gegenüberliegend des Überlaufes und auch zumindest teilweise angrenzend der Behälter-Rippen und der Trennwand-Rippen bzw. der mäanderförmigen Strömungskanäle des Getriebeöl-Kühlbereiches. Insgesamt ist somit eine besonders effektive Temperierung des Getriebeöls erreicht.

Es gibt nun eine Vielzahl von Möglichkeiten, den Antriebsstrang in vorteilhafter Art und Weise auszugestalten und weiterzubilden. Es darf hierzu zunächst auf die dem Patentanspruch 1 nachgeordneten Patentansprüche verwiesen werden. Im Folgenden wird nun eine bevorzugte Ausgestaltung des erfindungsgemäßen Antriebsstranges anhand der Zeichnung und der dazugehörigen Beschreibung näher erläutert bzw. beschrieben. In der Zeichnung zeigt:
- Fig.1a: in schematischer Darstellung ein Ausführungsbeispiel des Antriebsstranges in einer ersten, seitlichen Schnittansicht,
- Fig.1b: in schematischer Darstellung das Ausführungsbeispiel des Antriebsstranges in einer im Gegensatz zur ersten, seitlichen Schnittansicht aus Fig.1a leicht verdrehten und somit dreidimensionalen bzw. perspektivischen Ansicht,
- Fig.2a: in schematischer Darstellung das Ausführungsbeispiel des Antriebsstranges in einer Schnittansicht entlang der Linie A-A aus Fig.1a und somit in einer zweiten, seitlichen Schnittansicht, und
- Fig.2b: in schematischer Darstellung das Ausführungsbeispiel des Antriebsstranges in einer im Gegensatz zur zweiten, seitlichen Schnittansicht aus Fig.2a leicht verdrehten und somit dreidimensionalen bzw. perspektivischen Ansicht.

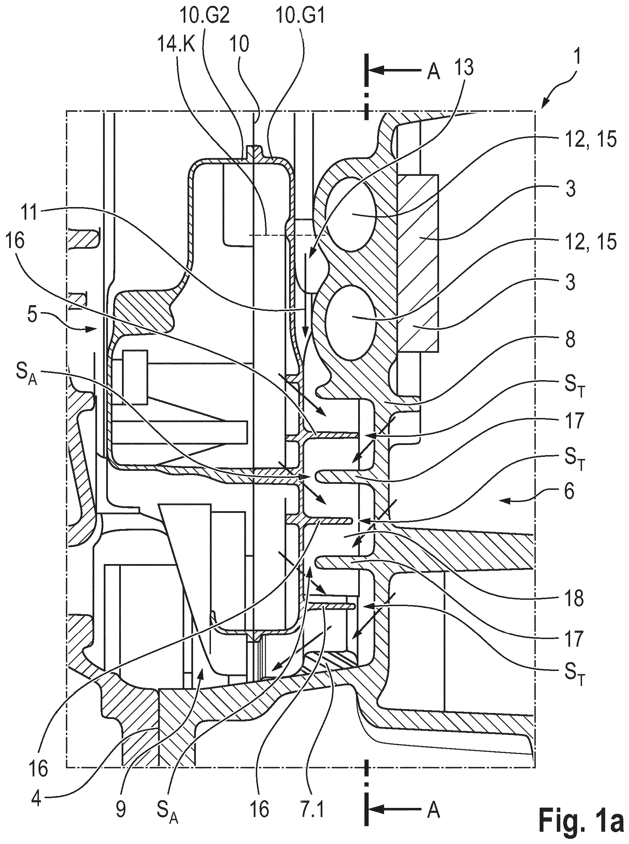

Fig.1a bis 2b zeigen einen Antriebsstrang 1, insbesondere für ein E-Fahrzeug, mit mindestens einem Getriebe 2, mit mindestens einer Leistungselektronik 3 und mit einem Gehäuse 4.

In dem Gehäuse 4 sind, insbesondere horizontal nebeneinander liegend, ein Getrieberaum 5 und ein Leistungselektronikraum 6 ausgebildet.

Das Getriebe 2 und/oder zumindest zwei Zahnräder 7.1, 7.2 zur Ausbildung von zumindest einer Getriebestufe 7 des Getriebes 2 ist bzw. sind in dem Getrieberaum 5 und die Leistungselektronik 3 ist in dem Leistungselektronikraum 6 angeordnet.

Der Getrieberaum 5 und der Leistungselektronikraum 6 sind mit Hilfe einer Trennwand 8 voneinander getrennt.

Das Getriebe 2 weist einen, insbesondere mittels des Gehäuses 4 ausgebildeten, Ölsumpf 9 und einen Auffangbehälter 10 auf, so dass im Betrieb des Getriebes 2 mit Hilfe zumindest eines der Zahnräder 7.1, 7.2 das im Ölsumpf 9 vorhandene Getriebeöl 11 emporschleuderbar und somit dem Auffangbehälter 10 zuführbar ist. Das Getriebeöl 11 selbst ist durch Strömungspfeile symbolisiert, welche die Strömungsrichtung des Getriebeöls 11 im Betrieb des Antriebsstranges 1 zeigen.

In dem Auffangbehälter 10 ist ein Hohlraum zur Aufnahme des Getriebeöls 11 ausgebildet. Der Auffangbehälter 10 weist eine Auffangöffnung auf, durch welche das Getriebeöl 11 mit Hilfe eines der Zahnräder 7.1, 7.2 aus dem Ölsumpf 9 durch das Emporschleudern dem Auffangbehälter 10 zuführbar ist.

Die Trennwand 8 weist mindestens einen Kühlkanal 12 auf. Der Auffangbehälter 10 ist zumindest teilweise beabstandet zur Trennwand 8 angeordnet. Ein Getriebeöl-Kühlbereich 13 ist zwischen dem Auffangbehälter 10 und der Trennwand 8 ausgebildet. Der Auffangbehälter 10 weist einen Überlauf 14 auf. Das Getriebeöl 11 ist über den Überlauf 14 dem Getriebeöl-Kühlbereich 13 zuführbar, mit Hilfe der Schwerkraft durch den Getriebeöl-Kühlbereich 13 hindurch führbar, und dabei mit Hilfe des im Kühlkanal 12 vorhandenen Kühlfluides 15 abkühlbar.

Der Überlauf 14 ist als eine Öffnung in einer Gehäusewand des Auffangbehälters 10 ausgebildet. Denkbar ist, dass auch mehrere Öffnungen vorgesehen und/oder vorhanden sind, die dann den Überlauf bilden bzw. ausbilden. Der Auffangbehälter 10 weist im Wesentlichen zwei Auffangbehälter-Gehäuseteile 10.G1, 10.G2 auf, welche miteinander verbunden sind. Der Auffangbehälter 10, insbesondere ein der Trennwand 8 zugewandtes Auffangbehälter-Gehäuseteil 10.G1, ist vorzugsweise mit der Trennwand 8, insbesondere mit Hilfe einer Schraubverbindung oder Klemmverbindung, verbunden. Der Überlauf 14 ist insbesondere als eine Öffnung der Gehäusewand in diesem der Trennwand 8 zugewandten Auffangbehälter-Gehäuseteil 10.G1 ausgebildet. Der Überlauf 14 ist insbesondere nierenförmig ausgebildet. Im Betrieb des Antriebsstranges 1 sammelt sich das Getriebeöl 11 in dem Auffangbehälter 10 steigt bis zum Überlauf 14 an und strömt dann bei weiterer Zufuhr von Getriebeöl 11 über den Überlauf 14 dem Getriebeöl-Kühlbereich 13 zu.

Der Auffangbehälter 10 weist an der der Trennwand 8 zugewandten Seite zumindest eine Behälter-Rippe 16 auf. Die Behälter-Rippe 16 ist vorzugsweise an dem der Trennwand 8 zugewandten Auffangbehälter-Gehäuseteil 10.G1 angeordnet und/oder ausgebildet. Zwischen der der Trennwand 8 zugewandten Stirnseite der Behälter-Rippe 16 und der Trennwand 8 ist insbesondere über die komplette Länge der Behälter-Rippe 16 ein Spalt S_{T} ausgebildet. Denkbar wäre demgegenüber aber auch, dass die Behälter-Rippe 16 die Trennwand 8 zumindest teilweise kontaktiert.

Die Trennwand 8 weist an der dem Auffangbehälter 10 zugewandten Seite zumindest eine Trennwand-Rippe 17 auf. Zwischen der dem Auffangbehälter 10 zugewandten Stirnseite der Trennwand-Rippe 17 und dem Auffangbehälter 10 ist insbesondere über die komplette Länge der Trennwand-Rippe 17 ebenso ein Spalt S_{A} ausgebildet. Denkbar wäre demgegenüber aber auch, dass die Trennwand-Rippe 17 den Auffangbehälter 10 zumindest teilweise kontaktiert. Die Trennwand-Rippe 17 geht vorzugsweise in eine insbesondere angrenzend zur Trennwand 8 ausgebildete Wandung des Gehäuses 4 über oder kontaktiert diese Wandung angrenzend zur Trennwand 8.

Der Auffangbehälter 10 weist zumindest zwei Behälter-Rippen 16 und die Trennwand 8 weist zumindest zwei Trennwand-Rippen 17 auf. Die Behälter-Rippen 16 und die Trennwand-Rippen 17 sind wechselsinnig angeordnet, insbesondere so dass mit Hilfe der Behälter-Rippen 16 und der Trennwand-Rippen 17 mäanderförmige Strömungskanäle 18 des Getriebeöl-Kühlbereiches 13 ausgebildet sind.

Zwischen einander zugewandten Seiten der Behälter-Rippen 16 und der Trennwand-Rippen 17 bilden sich die Strömungskanäle 18 aus, welche nacheinander ausgehend vom Überlauf 14 im Betrieb des Antriebsstranges 1 von oben nach unten durchströmt werden. Das Getriebeöl 11 ist dabei insbesondere mit Hilfe der Oberseiten der Behälter-Rippen 16 und der Trennwand-Rippen 17 führbar. Je nach Höhe des durch den Getriebeöl-Kühlbereich 13 fließenden Massenstromes des Getriebeöl 11 bildet sich ein mit Luft gefüllte Zwischenraum zwischen dem Getriebeöl 11 und den Unterseiten der Behälter-Rippen 16 und der Trennwand-Rippen 17 aus oder die Strömungskanäle 18 sind mit Getriebeöl 11 komplett gefüllt.

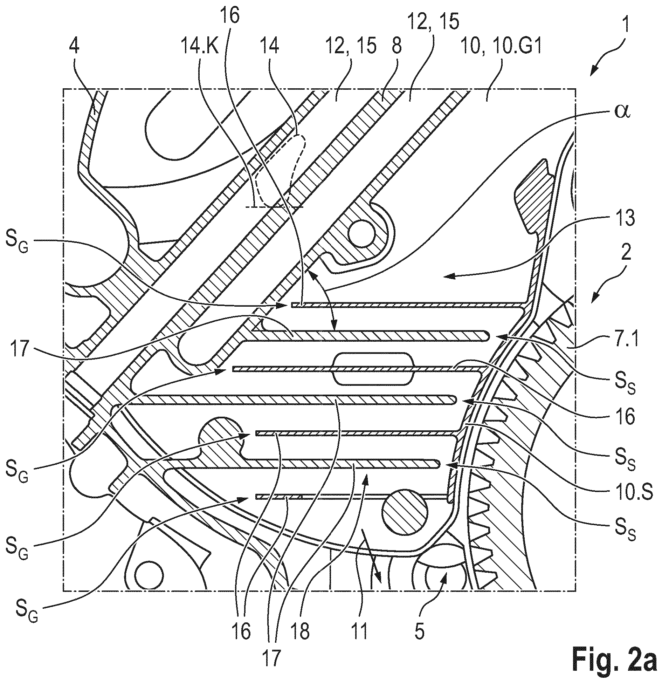

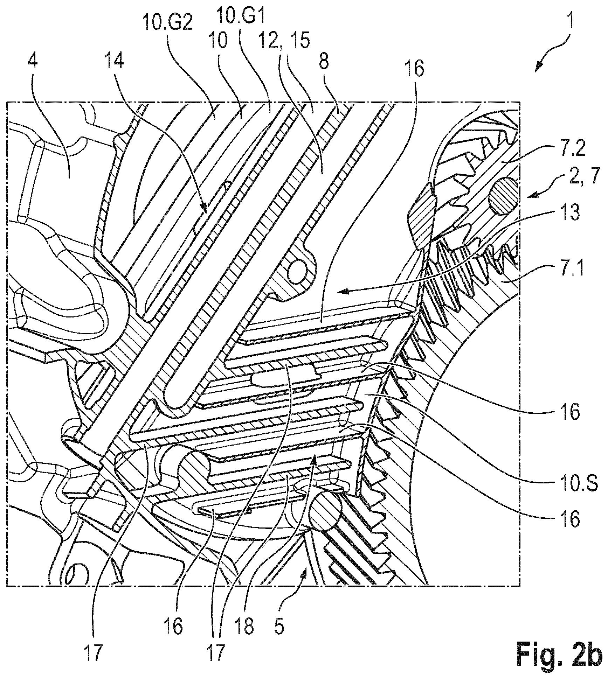

Die Behälter-Rippen 16 und die Trennwand-Rippen 17 sind im Wesentlichen waagerecht ausgerichtet. Das Getriebeöl 11 ist mit Hilfe der waagerecht ausgerichteten Behälter-Rippen 16 der Trennwand 8 zuführbar und mit Hilfe der waagerecht ausgerichteten Trennwand-Rippen 17 wieder von den Trennwand 8 wegführbar, wie mit Hilfe der Strömungspfeile in Fig.1a symbolisiert ist. Vorzugsweise ist nicht nur zwischen den Behälter-Rippen 16 und der Trennwand 8, sondern auch, wie insbesondere aus Fig.2a und 2b ersichtlich, zwischen den Behälter-Rippen 16 und dem Gehäuse 4 jeweils ein Spalt S_{G} ausgebildet, durch welchen das Getriebeöl 11 an der jeweiligen Behälter-Rippe 16 vorbei nach unten strömen kann.

Der Auffangbehälter 10 weist einen im Wesentlichen senkrecht zu den Behälter-Rippen 16 ausgebildeten Stegbereich 10.S auf, in welchen die Behälter-Rippen 16 übergehen. Dieser Stegbereich 10.S ist insbesondere entlang einer Außenkontur eines des Zahnräder 7.1 ausgerichtet, so dass mittels dieses Stegbereiches 10.S insbesondere vermieden ist, dass das Getriebeöl 11 direkt aus den durch die aus den Behälter-Rippen 16 und den Trennwand-Rippen 17 gebildeten Strömungskanälen 18, insbesondere durch eine Rotation des Zahnrades 7.1, "herausgesaugt" wird. Vorzugsweise ist nicht nur zwischen den Trennwand-Rippen 17 und dem Auffangbehälter 10, sondern auch, wie insbesondere aus Fig.2a und 2b ersichtlich, zwischen den Trennwand-Rippen 17 und dem Stegbereich 10.S jeweils ein Spalt S_{S} ausgebildet, durch welchen das Getriebeöl 11 an der jeweiligen Trennwand-Rippe 17 vorbei nach unten strömen kann, insbesondere entsprechend dann weiter bis zum Ölsumpf 9 strömen kann.

Die Behälter-Rippen 16 und die Trennwand-Rippen 17 sind unterhalb des Überlaufes 14, insbesondere unterhalb einer Überlaufkante 14.K des Überlaufes 14, angeordnet und/oder ausgebildet. Zwischen der Überlaufkante 14.K und der ersten der Behälter-Rippen 16 ist in senkrechter Richtung ein Abstand ausgebildet, so dass das Getriebeöl 11 im Betrieb des Antriebsstranges 1 nach Verlassen des Auffangbehälters 10 zunächst senkrecht zwischen dem Auffangbehälter 10 und der Trennwand 8 nach unten strömt.

Das Getriebeöl 11 ist aus dem Getriebeöl-Kühlbereich 13, insbesondere mit Hilfe der Schwerkraft, dem Ölsumpf 9 zuführbar. Zwischen dem Auffangbehälter 10, insbesondere auch zwischen einer letzten der Behälter-Rippen 16, und dem Gehäuse 4 ist dazu ein entsprechender Freiraum vorgesehen.

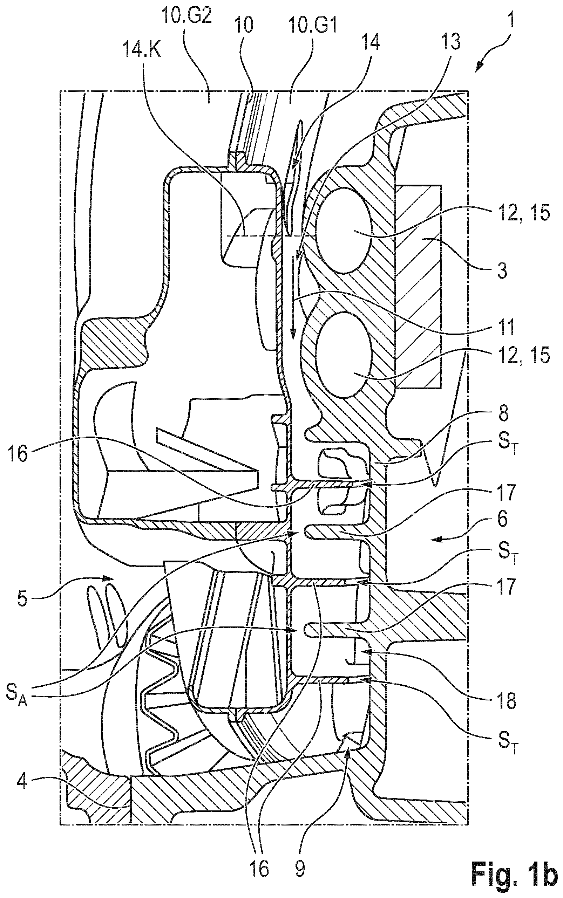

Die Leistungselektronik 3 liegt zumindest teilweise, insbesondere unter Ausbildung einer wärmeleitenden Verbindung, an der Trennwand 8 an, wie insbesondere Fig.1a und 1b zeigt. Die Leistungselektronik 3 ist zumindest teilweise angrenzend zum Kühlkanal 12 in dem Leistungselektronikraum 6 angeordnet. Der Überlauf 14 ist zumindest teilweise angrenzend zum Kühlkanal 12 in dem Getrieberaum 5 angeordnet, so dass das Getriebeöl 11 über den Überlauf 14 einem angrenzend zum Kühlkanal 12 ausgebildeten Teilbereich des Getriebeöl-Kühlbereiches 13 unmittelbar zuführbar ist. Das Getriebeöl 11 kontaktiert im Betrieb des Antriebsstranges 1 nach Verlassen des Auffangbehälters 10 somit zunächst den Bereich der Trennwand 8, in welchen der Kühlkanal 12 ausgebildet ist, so dass dann das Getriebeöl 11 und das Kühlfluid 15 nur durch einen dünnen Steg der Trennwand 8 voneinander getrennt sind, durch welchen ein hoher Wärmeübergang ermöglicht ist. Diese Position des Überlaufes 14 ist insbesondere auch aus der Darstellung des Überlaufes 14 aus Fig.2a ersichtlich, wobei der Überlauf 14 aufgrund der Perspektive hier hinter den Kühlkanälen 12 angeordnet ist und deswegen hier mit gestrichelten Linien dargestellt ist.

Die Trennwand 8 weist mehrere, vorzugsweise gerade verlaufende Kühlkanäle 12 auf. Insbesondere sind die Kühlkanäle 12 mit Hilfe jeweils einer in das Gehäuse 4 eingebrachten Bohrung ausgebildet. Insbesondere weisen die Kühlkanäle 12 einen bestimmten Winkel α zu den Behälter-Rippen 16 und den Trennwand-Rippen 17 auf. Insbesondere sind zwei Kühlkanäle 12 vorgesehen, wobei das Kühlfluid 15 z.B. mit Hilfe einer Kühlfluid-Pumpe einem der zwei Kühlkanäle 12 zuführbar ist und wobei das Kühlfluid 15, insbesondere mit Hilfe derselben Kühlfluid-Pumpe aus dem anderen der zwei Kühlkanäle 12 unter Ausbildung eines Kühlfluid-Strömungskreislaufes wieder abführbar ist.

In der sehr bevorzugten Ausführungsform ist der Antriebsstrang 1 insbesondere für ein E-Fahrzeug ausgebildet. Es ist daher eine Elektromaschine vorgesehen und/oder vorhanden, wobei mit Hilfe der Leistungselektronik 3 insbesondere die Elektromaschine und/oder das Getriebe 2 entsprechend steuerbar und/oder ansteuerbar ist.

In den Fig. 1 und 2 ist hier insbesondere die zuvor genannte Elektromaschine nicht im Einzelnen explizit dargestellt. Bei dieser erwähnten bevorzugten Ausführungsform des Antriebsstranges wird dann aber nicht nur das Getriebe 2, sondern auch die Elektromaschine zumindest teilweise über den zuvor oben geschilderten Ölkreislauf, insbesondere über den oben beschriebenen Getriebeöl-Kühlkreislauf insbesondere zusätzlich mit gekühlt. Nochmal anders ausgedrückt: Das Getriebe 2 und die entsprechende Elektromaschine werden dann über einen zumindest teilweise gemeinsam ausgebildeten Getriebeöl-Kreislauf gekühlt. Hierbei wird das sich im Ölsumpf 9 sammelnde Getriebeöl dann auch zur Kühlung der Elektromaschine entsprechend verwendet. Der hier verwendete Ausdruck "Getriebeöl" ist daher nicht einschränkend zu verstehen, sondern hiermit ist auch allgemein dann der Begriff eines "Kühlmittels und/oder Schmiermittels" zur Kühlung der Elektromaschine mit umfasst, mit dessen Hilfe dann das Getriebe 2 und die Elektromaschine gekühlt werden kann. Insbesondere wird das zur Kühlung der Elektromaschine dann der Elektromaschine auch zugeführte Getriebeöl dann auch dem Auffangbehälter 10 entnommen und der Elektromaschine, insbesondere einer Rotorwelle der Elektromaschine zugeführt. Hierzu kann der Auffangbehälter 10 insbesondere einen weiteren Überlauf zur Leitung des Getriebeöls zur Rotorwelle der Elektromaschine aufweisen. Hierbei wird dann das die Elektromaschine kühlende Getriebeöl nach der Kühlung der Elektromaschine dann dem Ölsumpf 9 zugeleitet bzw. hierhin zurück geleitet, auch hierauf darf explizit nochmals hingewiesen werden.

### Bezugszeichenliste

- 1: Antriebsstrang
- 2: Getriebe
- 3: Leistungselektronik
- 4: Gehäuse
- 5: Getrieberaum
- 6: Leistungselektronikraum
- 7: Getriebestufe
- 7.1: erstes Zahnrad der Getriebestufe 7
- 7.2: zweites Zahnrad der Getriebestufe 7
- 8: Trennwand
- 9: Ölsumpf
- 10: Auffangbehälter
- 10.G1: erster Auffangbehälter-Gehäuseteil des Auffangbehälters 10
- 10.G2: zweiter Auffangbehälter-Gehäuseteil des Auffangbehälters 10
- 10.S: Stegbereich des Auffangbehälters 10
- 11: Getriebeöl
- 12: Kühlkanal
- 13: Getriebeöl-Kühlbereich
- 14: Überlauf
- 14.K: Überlaufkante
- 15: Kühlfluid
- 16: Behälter-Rippe
- 17: Trennwand-Rippe
- 18: mäanderförmige Strömungskanäle des Getriebeöl-Kühlbereiches 13

- α: Winkel
- S_{T}: Spalt zur Trennwand 8
- S_{G}: Spalt zum Gehäuse 4
- S_{A}: Spalt zum Auffangbehälter 10
- S_{S}: Spalt zum Stegbereich 10.S

## Patentansprüche

1. Antriebsstrang (1), insbesondere für ein E-Fahrzeug, mit mindestens einem Getriebe (2), mit mindestens einer Leistungselektronik (3) und mit einem Gehäuse (4), wobei in dem Gehäuse (4), insbesondere horizontal nebeneinander liegend, ein Getrieberaum (5) und ein Leistungselektronikraum (6) ausgebildet sind, wobei das Getriebe (2) und/oder zumindest zwei Zahnräder (7.1, 7.2) zur Ausbildung von zumindest einer Getriebestufe (7) des Getriebes (2) in dem Getrieberaum (5) und die Leistungselektronik (3) in dem Leistungselektronikraum (6) angeordnet ist, wobei der Getrieberaum (5) und der Leistungselektronikraum (6) mit Hilfe einer Trennwand (8) voneinander getrennt sind, wobei das Getriebe (2) einen, insbesondere mittels des Gehäuses (4) ausgebildeten, Ölsumpf (9) und einen Auffangbehälter (10) aufweist, so dass im Betrieb des Getriebes (2) mit Hilfe zumindest eines der Zahnräder (7.1, 7.2) das im Ölsumpf (9) vorhandene Getriebeöl (11) emporschleuderbar und somit dem Auffangbehälter (10) zuführbar ist, wobei die Trennwand (8) mindestens einen Kühlkanal (12) aufweist, wobei der Auffangbehälter (10) zumindest teilweise beabstandet zur Trennwand (8) angeordnet ist, wobei ein Getriebeöl-Kühlbereich (13) zwischen dem Auffangbehälter (10) und der Trennwand (8) ausgebildet ist, und wobei der Auffangbehälter (10) einen Überlauf (14) aufweist, **dadurch gekennzeichnet, dass** das Getriebeöl (11) über den Überlauf (14) dem Getriebeöl-Kühlbereich (13) zuführbar, mit Hilfe der Schwerkraft durch den Getriebeöl-Kühlbereich (13) hindurch führbar, und dabei mit Hilfe des im Kühlkanal (12) vorhandenen Kühlfluides (15) abkühlbar ist.

2. Antriebsstrang (1) nach Anspruch 1, **dadurch gekennzeichnet, dass** der Auffangbehälter (10) an der der Trennwand (8) zugewandten Seite zumindest eine Behälter-Rippe (16) aufweist.

3. Antriebsstrang (1) nach Anspruch 1 oder 2, **dadurch gekennzeichnet, dass** die Trennwand (8) an der dem Auffangbehälter (10) zugewandten Seite zumindest eine Trennwand-Rippe (17) aufweist.

4. Antriebsstrang (1) nach einem der Ansprüche 1 bis 3, **dadurch gekennzeichnet, dass** der Auffangbehälter (10) zumindest zwei Behälter-Rippen (16) und die Trennwand (8) zumindest zwei Trennwand-Rippen (17) aufweist, wobei die Behälter-Rippen (16) und die Trennwand-Rippen (17) wechselsinnig angeordnet sind, so dass mit Hilfe der Behälter-Rippen (16) und der Trennwand-Rippen (17) mäanderförmige Strömungskanäle (18) des Getriebeöl-Kühlbereiches (13) ausgebildet sind.

5. Antriebsstrang (1) nach einem der Ansprüche 2 bis 4, **dadurch gekennzeichnet, dass** die Behälter-Rippen (16) und die Trennwand-Rippen (17) im Wesentlichen waagerecht ausgerichtet sind.

6. Antriebsstrang (1) nach einem der Ansprüche 2 bis 5, **dadurch gekennzeichnet, dass** die Behälter-Rippen (16) und die Trennwand-Rippen (17) unterhalb des Überlaufes (14), unterhalb einer Überlaufkante (14.K) des Überlaufes (14), angeordnet und/oder ausgebildet sind.

7. Antriebsstrang (1) nach einem der vorangehenden Ansprüche, **dadurch gekennzeichnet, dass** das Getriebeöl (11) aus dem Getriebeöl-Kühlbereich (13), mit Hilfe der Schwerkraft, dem Ölsumpf (9) zuführbar ist.

8. Antriebsstrang (1) nach einem der vorangehenden Ansprüche, **dadurch gekennzeichnet, dass** die Leistungselektronik (3) zumindest teilweise, unter Ausbildung einer wärmeleitenden Verbindung, an der Trennwand (8) anliegt.

9. Antriebsstrang (1) nach einem der vorangehenden Ansprüche, **dadurch gekennzeichnet, dass** die Leistungselektronik (3) zumindest teilweise angrenzend zum Kühlkanal (12) in dem Leistungselektronikraum (6) angeordnet ist, wobei der Überlauf (14) zumindest teilweise angrenzend zum Kühlkanal (12) in dem Getrieberaum (5) angeordnet ist, so dass das Getriebeöl (11) über den Überlauf (14) einem angrenzend zum Kühlkanal (12) ausgebildeten Teilbereich des Getriebeöl-Kühlbereiches (13) unmittelbar zuführbar ist.

10. Antriebsstrang (1) nach Anspruch 2 und 3 oder nach Anspruch 2 und 3 in Kombination mit einem der Ansprüche 4 bis 9, **dadurch gekennzeichnet, dass** die Trennwand (8) mehrere, gerade verlaufende Kühlkanäle (12) aufweist, wobei die Kühlkanäle (12) mit Hilfe jeweils einer in das Gehäuse (4) eingebrachten Bohrung ausgebildet sind, und wobei die entsprechend ausgebildeten Kühlkanäle (12) einen Winkel (α) zu den Behälter-Rippen (16) und den Trennwand-Rippen (17) aufweisen.

## Claims

1. Drive train (1), in particular for an electric vehicle, comprising at least one transmission (2), at least one power electronics unit (3) and a housing (4), with a transmission chamber (5) and a power electronics chamber (6) being formed in the housing (4), in particular lying horizontally next to one another, the transmission (2) and/or at least two gearwheels (7.1, 7.2) for forming at least one transmission stage (7) of the transmission (2) being arranged in the transmission chamber (5), and the power electronics unit (3) being arranged in the power electronics chamber (6), the transmission chamber (5) and the power electronics chamber (6) being separated from one another by means of a partition wall (8), the transmission (2) comprising an oil sump (9), formed in particular by means of the housing (4), and a collecting container (10), so that during operation of the transmission (2) by means of at least one of the gearwheels (7.1, 7.2), the transmission oil (11) present in the oil sump (9) can be expelled upward and can thus be fed to the collecting container (10), the partition wall (8) comprising at least one cooling channel (12), the collecting container (10) being arranged at least partially at a distance from the partition wall (8), a transmission oil cooling region (13) being formed between the collecting container (10) and the partition wall (8), and the collecting container (10) comprising an overflow (14), **characterized in that** the transmission oil (11) can be fed to the transmission oil cooling region (13) via the overflow (14), can be guided through the transmission oil cooling region (13) by means of gravity, and can thus be cooled by means of the cooling fluid (15) present in the cooling channel (12).

2. Drive train (1) according to claim 1, **characterized in that** the collecting container (10) comprises at least one container rib (16) on the side facing the partition wall (8).

3. Drive train (1) according to claim 1 or claim 2, **characterized in that** the partition wall (8) comprises at least one partition wall rib (17) on the side facing the collecting container (10).

4. Drive train (1) according to any of claims 1 to 3, **characterized in that** the collecting container (10) comprises at least two container ribs (16) and the partition wall (8) comprises at least two partition wall ribs (17), the container ribs (16) and the partition wall ribs (17) being arranged alternately, so that meandering flow channels (18) of the transmission oil cooling region (13) are formed by means of the container ribs (16) and the partition wall ribs (17).

5. Drive train (1) according to any of claims 2 to 4, **characterized in that** the container ribs (16) and the partition wall ribs (17) are aligned substantially horizontally.

6. Drive train (1) according to any of claims 2 to 5, **characterized in that** the container ribs (16) and the partition wall ribs (17) are arranged and/or formed below the overflow (14), below an overflow edge (14.K) of the overflow (14).

7. Drive train (1) according to any of the preceding claims,
**characterized in that** the transmission oil (11) can be fed from the transmission oil cooling region (13) to the oil sump (9) by means of gravity.

8. Drive train (1) according to any of the preceding claims,
**characterized in that** the power electronics unit (3) rests at least partially against the partition wall (8), forming a heat-conducting connection.

9. Drive train (1) according to any of the preceding claims,
**characterized in that** the power electronics unit (3) is arranged at least partially adjacent to the cooling channel (12) in the power electronics chamber (6), the overflow (14) being arranged at least partially adjacent to the cooling channel (12) in the transmission chamber (5), so that the transmission oil (11) can be fed directly via the overflow (14) to a partial region of the transmission oil cooling region (13), which partial region is formed adjacently to the cooling channel (12).

10. Drive train (1) according to claim 2 and claim 3 or according to claim 2 and claim 3 in combination with any of claims 4 to 9,**characterized in that** the partition wall (8) comprises a plurality of straight cooling channels (12), the cooling channels (12) each being formed by means of a bore made in the housing (4), and the correspondingly formed cooling channels (12) having an angle (α) to the container ribs (16) and to the partition wall ribs (17).

## Revendications

1. Chaîne cinématique (1), en particulier pour un véhicule électrique, comportant au moins une boîte de vitesses (2), comportant au moins une électronique de puissance (3) et comportant un boîtier (4), dans laquelle un compartiment de boîte de vitesses (5) et un compartiment d'électronique de puissance (6) sont formés dans le boîtier (4), en particulier horizontalement côte à côte, dans laquelle la boîte de vitesses (2) et/ou au moins deux roues dentées (7.1, 7.2) pour former au moins un étage de boîte de vitesses (7) de la boîte de vitesses (2) sont agencées dans le compartiment de boîte de vitesses (5) et l'électronique de puissance (3) est agencée dans le compartiment d'électronique de puissance (6), dans laquelle le compartiment de boîte de vitesses (5) et le compartiment d'électronique de puissance (6) sont séparés l'un de l'autre à l'aide d'une paroi de séparation (8), dans laquelle la boîte de vitesses (2) présente un carter d'huile (9), réalisé en particulier par le biais du boîtier (4), et un récipient collecteur (10), de sorte que, pendant le fonctionnement de la boîte de vitesses (2), à l'aide d'au moins l'une des roues dentées (7.1, 7.2), l'huile de boîte de vitesses (11) présente dans le carter d'huile (9) peut être projetée vers le haut et ainsi être amenée au récipient collecteur (10), dans laquelle la paroi de séparation (8) présente au moins un canal de refroidissement (12), dans laquelle le récipient collecteur (10) est agencé au moins partiellement à distance de la paroi de séparation (8), dans laquelle une zone de refroidissement d'huile de boîte de vitesses (13) est formée entre le récipient collecteur (10) et la paroi de séparation (8), et dans laquelle le récipient collecteur (10) présente un trop-plein (14), **caractérisée en ce que** l'huile de boîte de vitesses (11) peut être amenée par l'intermédiaire du trop-plein (14) à la zone de refroidissement d'huile de boîte de vitesses (13), peut être guidée à l'aide de la force de gravité à travers la zone de refroidissement d'huile de boîte de vitesses (13), et peut être refroidie à l'aide du fluide de refroidissement (15) présent dans le canal de refroidissement (12).

2. Chaîne cinématique (1) selon la revendication 1, **caractérisée en ce que** le récipient collecteur (10) présente au moins une nervure de récipient (16) sur le côté tourné vers la paroi de séparation (8).

3. Chaîne cinématique (1) selon la revendication 1 ou 2,
**caractérisée en ce que** la paroi de séparation (8) présente au moins une nervure de paroi de séparation (17) sur le côté tourné vers le récipient collecteur (10).

4. Chaîne cinématique (1) selon l'une des revendications 1 à 3, **caractérisée en ce que** le réservoir collecteur (10) présente au moins deux nervures de réservoir (16) et la paroi de séparation (8) au moins deux nervures de paroi de séparation (17), dans laquelle les nervures de réservoir (16) et les nervures de paroi de séparation (17) sont agencées en sens alternés, de sorte que des canaux d'écoulement (18) en forme de méandres de la zone de refroidissement d'huile de boîte de vitesses (13) sont formés à l'aide des nervures de réservoir (16) et des nervures de paroi de séparation (17).

5. Chaîne cinématique (1) selon l'une des revendications 2 à 4, **caractérisée en ce que** les nervures de réservoir (16) et les nervures de paroi de séparation (17) sont orientées sensiblement à l'horizontale.

6. Chaîne cinématique (1) selon l'une des revendications 2 à 5, **caractérisée en ce que** les nervures de réservoir (16) et les nervures de paroi de séparation (17) sont agencées et/ou formées en dessous du trop-plein (14), en dessous d'un bord de trop-plein (14.K) du trop-plein (14).

7. Chaîne cinématique (1) selon l'une des revendications précédentes, **caractérisée en ce que** l'huile de boîte de vitesses (11) peut être amenée au carter d'huile (9) à partir de la zone de refroidissement d'huile de boîte de vitesses (13), à l'aide de la force de gravité.

8. Chaîne cinématique (1) selon l'une des revendications précédentes, **caractérisée en ce que** l'électronique de puissance (3) s'appuie au moins partiellement sur la paroi de séparation (8) en formant une liaison thermoconductrice.

9. Chaîne cinématique (1) selon l'une des revendications précédentes, **caractérisée en ce que** l'électronique de puissance (3) est agencée au moins partiellement de manière adjacente au canal de refroidissement (12) dans le compartiment d'électronique de puissance (6), dans laquelle le trop-plein (14) est agencé au moins partiellement de manière adjacente au canal de refroidissement (12) dans le compartiment de boîte de vitesses (5), de sorte que l'huile de boîte de vitesses (11) peut être amenée directement par l'intermédiaire du trop-plein (14) à une zone partielle de la zone de refroidissement d'huile de boîte de vitesses (13) réalisée de manière adjacente au canal de refroidissement (12).

10. Chaîne cinématique (1) selon les revendications 2 et 3 ou selon les revendications 2 et 3 en combinaison avec l'une des revendications 4 à 9, **caractérisée en ce que** la paroi de séparation (8) présente plusieurs canaux de refroidissement (12) s'étendant en ligne droite, dans laquelle les canaux de refroidissement (12) sont formés à l'aide respectivement d'un alésage pratiqué dans le boîtier (4), et dans laquelle les canaux de refroidissement (12) formés de manière correspondante présentent un angle (α) par rapport aux nervures de réservoir (16) et aux nervures de paroi de séparation (17).
